# EUROPÄISCHE PATENTSCHRIFT

(11) **EP 2 036 410 B1**
(45) Veröffentlichungstag und Bekanntmachung des Hinweises auf die Patenterteilung: **14.10.2015**
(21) Anmeldenummer: 07730079.6
(22) Anmeldetag: 12.06.2007
(51) Int. Cl.: H05K 1/18, H05K 7/14

(54) **Verfahren zur Fixierung einer Leiterplatte in einem Gehäuse und Anordnung mit einem Gehäuse, einer Leiterplatte und einem Fixierelement**
Method for fixing a circuit board in a housing and arrangement with a housing, a circuit board and a fixing element
Procédé de fixation d'une carte de circuit imprimé dans un boîtier et arrangement avec un boîtier, une carte de circuit imprimé et un élément de fixation

(30) Priorität: 16.06.2006 DE 102006027779
(43) Veröffentlichungstag der Anmeldung: 18.03.2009
(73) Patentinhaber: Robert Bosch GmbH, 70442 Stuttgart (DE)
(72) Erfinder: HENNEL, Udo, 74321 Bietigheim-Bissingen (DE); GEISSLER, Alexander, 07616 Buergel (DE)
(86) Internationale Anmeldenummer: PCT/EP2007/055750
(87) Internationale Veröffentlichungsnummer: WO 2007/147750

(56) Entgegenhaltungen:
- EP-A- 0 359 223
- DE-U1- 29 724 785
- US-A- 3 688 635
- US-A- 5 999 414
- US-A1- 2002 149 916

## Beschreibung

Die Erfindung betrifft ein Verfahren zur Fixierung einer Leiterplatte, in einem als Aufnahme für die Leiterplatte dienenden Gehäuse gemäß dem Oberbegriff des Anspruchs 1, sowie eine Anordnung aus einer Leiterplatte, einem Gehäuse und einem Fixierelement zur Fixierung der Leiterplatte in dem Gehäuse durch Festklemmen gemäß dem Oberbegriff des Anspruchs 4.

### Stand der Technik

Zur Fixierung von elektrischen oder elektronischen Bauteilen und insbesondere von Leiterplatten in einem umgebenden Gehäuse gibt es verschiedenste technische Lösungen. Zum Beispiel kann die Leiterplatte im Gehäuse festgeschraubt oder festgeklebt oder durch Einclipsen mit dem Gehäuse verbunden werden. Jedoch sind derartige Verbindungen nicht frei von Nachteilen. Während eine Klebeverbindung nach dem Herstellen nicht mehr lösbar ist und zudem durch chemische Inhaltsstoffe des verwendeten Klebers zu einer Beschädigung der Leiterplatte oder der darauf montierten Komponenten führen kann, sind Schraubverbindungen und Einclipsverbindungen zwar lösbar, stellen jedoch hohe Anforderungen an die Toleranzen der Leiterplatte und des Gehäuses. Letzteres gilt auch für bereits an sich bekannte Klemmverbindungen, bei denen zum Beispiel eine Leiterplatte beim Verschließen des Gehäuses zwischen zwei Gehäusehälften unmittelbar festgeklemmt wird. Außerdem können dort die mechanischen Belastungen der Leiterplatte sehr hoch sein.

Aus der DE 297 24 785 U1 ist ein Verbindungselement bekannt, das aus elektrisch leitfähigem Kunststoff besteht, und das sowohl zur elektrischen, als auch zur mechanischen Fixierung eines Schaltungsträgers verwendet wird. Das Verbindungselement wird dabei auf dem Schaltungsträger angebracht. Es weist einen elastisch nachgiebigen Andruckteil auf, der beim Festklemmen des Schaltungsträgers in einem Gehäuse mit einem Teil des Gehäuses zur Anlage gebracht und unter Verformung gegen diesen angepresst wird.

Aus der US 3 688 635 A ist ein Verfahren zur Fixierung einer Leiterplatte in einem Gehäuse bekannt, bei dem die Leiterplatte in dem Gehäuse festgeklemmt wird. Dabei wird ein Fixierelement mit einem Ende in die Leiterplatte eingepresst. Am anderen Ende wird das Fixierelement mit dem Gehäuse verbunden. Am gehäuseseitigen Ende des Fixierelements ist weiterhin ein federartig ausgebildeter Abschnitt angeordnet, so dass die Leiterplatte durch eine Verformung des federartigen Abschnitts in dem Gehäuse festgeklemmt wird.

Aus der US 2002/149916 A1 ist ein elektronisches Gerät bekannt, bei dem eine Leiterplatte in einem Gehäuse befestigt ist. Zum Schutz und zur Dämpfung von Vibrationen ist die Leiterplatte über Kontaktelemente befestigt, die in die Leiterplatte eingepresst sind und einen elastisch verformbaren Abschnitt aufweisen. Die Kontaktelemente sind über Dämpfungselemente mit dem Gehäuse verbunden.

Ausgehend hiervon liegt der Erfindung die Aufgabe zugrunde, ein Verfahren, ein Fixierelement und eine Leiterplatte der eingangs genannten Art dahingehend zu verbessern, dass eine sichere, feste und dauerhafte Fixierung der Leiterplatte im Gehäuse ohne besondere Toleranzanforderungen möglich ist.

### Offenbarung der Erfindung

Diese Aufgabe wird erfindungsgemäß dadurch gelöst, dass die Leiterplatte mit mindestens einem Fixierelement bestückt wird, das einen elastisch nachgiebigen Andruckteil umfasst, der beim Festklemmen der Leiterplatte im Gehäuse mit einem Teil des Gehäuses zur Anlage gebracht und unter Verformung gegen diesen angepresst wird.

Der Erfindung liegt der Gedanke zugrunde, an den Schnittstellen zwischen der Leiterplatte und dem Gehäuse, das heißt dort, wo die Klemmkräfte vom Gehäuse auf die Leiterplatte übertragen werden, an Stelle einer direkten Übertragung der Klemmkräfte eine indirekte Übertragung über ein zwischen die Leiterplatte und das Gehäuse eingefügtes elastisch nachgiebiges Zwischenglied zu wählen, um im Bereich der Klemmverbindung Toleranzen bzw. ein eventuell vorhandenes Spiel auszugleichen. Da sich der elastisch nachgiebige Andruckteil entsprechend den jeweiligen Einbaubedingungen mehr oder weniger stark verformen kann, können die Toleranzanforderungen an das Gehäuse und an die Leiterplatte selbst erheblich verringert werden. Weiter können über den elastisch nachgiebigen Andruckteil des mindestens einen Fixierelements unterschiedliche Wärmedehnungen der Leiterplatte und des Gehäuses ausgeglichen werden. Außerdem lässt sich mit Hilfe des elastisch nachgiebigen Andruckteils die Kontaktfläche zwischen der Leiterplatte und dem Gehäuse vergrößern, was durch geringere Flächenpressungen zu einer Reduzierung der durch die Klemmverbindung verursachten mechanischen Belastungen und damit zu einer Verlängerung der Lebensdauer der Leiterplatte führt. Darüber hinaus wirkt der elastisch nachgiebige Andruckteil bei geeigneter Materialwahl auch als Dämpfungsglied, das eine Übertragung von Schwingungen aus dem Gehäuse auf das Bauteil dämpft und somit zumindest teilweise für eine schwingungstechnische Entkopplung der Leiterplatte vom Gehäuse sorgt.

Eine bevorzugte Ausgestaltung des erfindungsgemäßen Verfahrens sieht vor, dass das Fixierelement durch Löten auf Leiterplatte befestigt wird. Diese Art der Befestigung hat den Vorteil, dass sich das Fixierelement in derselben Weise wie andere, auf der Leiterplatte zu montierende Komponenten mit vorhandenen Bestückungsautomaten anbringen lässt, so dass die Leiterplatte im Zuge ihrer Herstellung mit geringem zusätzlichem Aufwand mit dem oder den Fixierelementen bestückt werden kann.

Bei anderen elektronischen oder elektrischen Bauteilen, die ebenfalls durch Festklemmen in einem Gehäuse fixiert werden können, wie zum Beispiel Elektrolytkondensatoren, Kontaktfahnen oder dergleichen, kann das Fixierelement zweckmäßig durch Festkleben auf dem Bauteil befestigt werden, was ebenfalls bereits vor der Montage des Bauteils im Gehäuse ohne großen Mehraufwand möglich ist.

Erfindungsgemäß besteht der Andruckteil des Fixierelements mindestens teilweise aus einem Elastomermaterial, wie einem Polyurethanschaum oder einem thermoplastischen Elastomer (TPE). Jedoch kann auch ein gummielastisches Material verwendet werden, zum Beispiel ein Ethylen-Propylen-Dien-Kautschuk (EPDM) oder Silikon, solange dieses Material beim Aufbringen einer Klemmkraft elastisch nachgiebig ist und sich ohne Schwierigkeiten auf einem geeigneten Träger des Fixierelements anbringen lässt.

Eine weitere bevorzugte Ausgestaltung der Erfindung sieht vor, das Fixierelement auch zur Kontaktierung zwischen der Leiterplatte, und dem umgebenden Gehäuse zu verwenden, indem der Andruckteil und ein auf den Andruckteil einwirkender Teil des Gehäuses mindestens teilweise aus einem elektrisch leitenden Material hergestellt werden, das im Falle des Andruckteils vorzugsweise aus einem mit Graphit gefüllten Elastomer besteht und im Falle des Gehäuseteils zweckmäßig als metallischer Kontaktfinger ausgebildet sein kann. Auf diese Weise werden zusätzliche Kontaktmaßnahmen zwischen der Leiterplatte und seinem Gehäuse überflüssig.

### Kurze Beschreibung der Zeichnungen

Die Erfindung wird nachfolgend in einigen Ausführungsformen anhand der zugehörigen Zeichnungen näher erläutert. Es zeigen:
Fig. 1 eine perspektivische Ansicht einer mit vier Fixierelementen bestückten Leiterplatte;
Fig. 2 eine Draufsicht auf eines der Fixierelemente aus Fig. 1;
Fig. 3 eine Seitenansicht des Fixierelements aus Fig. 2 vor der Montage auf der Leiterplatte;
Fig. 4 eine Seitenansicht des Fixierelements aus Fig. 2 nach der Montage auf der Leiterplatte;
Fig. 5 eine Draufsicht auf ein modifiziertes Fixierelement;
Fig. 6 eine Seitenansicht des Fixierelements aus Fig. 5 vor der Montage auf einer Leiterplatte;
Fig. 7 eine teilweise geschnittene Seitenansicht des Fixierelements aus Fig. 5 nach der Montage auf einer Leiterplatte;
Fig. 8 eine vergrößerte Ansicht des Ausschnitts A in Fig. 7;
Fig. 9 eine Seitenansicht und eine Draufsicht auf einen Teil einer Leiterplatte mit einem im Kontakt mit Masse stehenden Fixierelement, das einen elektrisch nicht-leitenden Andruckteil aufweist;
Fig. 10 eine Seitenansicht und eine Draufsicht auf einen Teil einer Leiterplatte mit einem im Kontakt mit Masse stehenden Fixierelement, das einen elektrisch leitenden Andruckteil aufweist;
Figuren 11 bis 15 Seiten- bzw. Schnittansichten von Fixierelementen mit unterschiedlich geformten Andruckteilen.
Figuren 16 und 17 Schnittansichten von erfindungsgemäß ausgebildeten Fixierelementen.

### Ausführungsformen der Erfindung

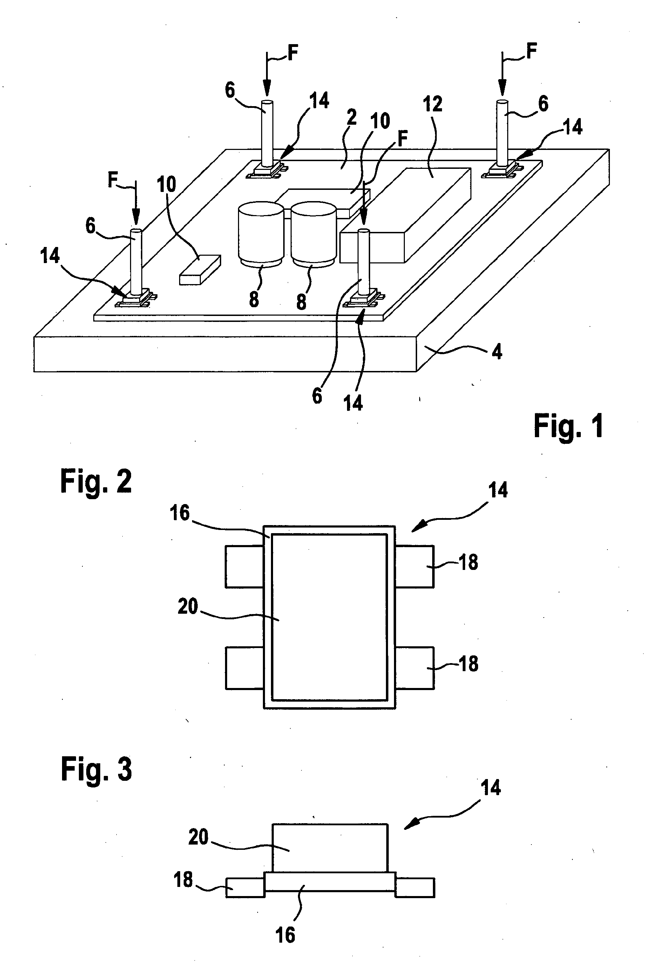

Die in der Zeichnung am besten in Fig. 1 dargestellte Leiterplatte 2 wird mittels einer Klemmverbindung in einem Gehäuse fixiert, indem sie von oben her mit ihrer Unterseite gegen einen festen ebenen Untergrund 4, zum Beispiel einen Boden des Gehäuses, angepresst wird. Das Anpressen der Leiterplatte 2 gegen den Untergrund 4 erfolgt mit Hilfe einer Mehrzahl von zylindrischen Haltedornen oder dergleichen langgestreckten Gehäusevorsprüngen 6, die beispielsweise über die Unterseite eines Deckels (nicht dargestellt) des Gehäuses überstehen und beim Schließen des Deckels vorbei an einer Mehrzahl von auf der Oberseite der Leiterplatte 2 montierten elektronischen Komponenten, wie Kondensatoren 8, Speicherchips 10, Prozessoren 12 und dergleichen, nach unten bis in die Nähe der Leiterplatte 2 ragen, wo sie jeweils eine Klemmkraft (Pfeile F) auf ein unterhalb jedes Vorsprungs 6 starr auf der Oberseite der Leiterplatte 2 montiertes Fixierelement 14 ausüben, um das Fixierelement 14 und über dieses die Leiterplatte 2 nach unten gegen den Untergrund 4 anzupressen und so für eine Fixierung der Leiterplatte 2 im Gehäuse zu sorgen.

Wie am besten in Fig. 2, 3 und 4 dargestellt, bestehen die Fixierelemente 14 im Wesentlichen aus einem Grundträger 16, der mit Hilfe von vier seitlich überstehenden Pins 18 auf der Leiterplatte 2 festgelötet ist und der auf seiner von der Leiterplatte 2 abgewandten Oberseite mit einem elastisch nachgiebigen oder verformbaren Andruckteil 20 versehen ist, mit dem der Gehäusevorsprung 6 in Eingriff tritt, um die Leiterplatte 2 zwischen dem Gehäusevorsprung 6 und dem Untergrund 4 festzuklemmen.

Während der Grundträger 16 und die Pins 18 aus einem gut lötbaren, elektrisch leitenden Metall, wie Kupfer, bestehen, kann der Andruckteil 20 je nach Größe der auszugleichenden Toleranz und der aufgebrachten Klemmkraft aus einem Elastomermaterial, wie einem Polyurethanschaum oder einem thermoplastischen Elastomer (TPE), einem elastisch nachgiebigen thermoplastischen Kunststoffmaterial, wie Polytetrafluorethylen (PTFE), oder einem gummielastischen Material, wie einem Ethylen-Propylen-Dien-Kautschuk (EPDM) oder Silikon, bestehen, das sich beim Aufbringen einer Klemmkraft mehr oder weniger stark elastisch verformt und nach der Entlastung wieder in seine Ausgangslage zurückkehrt.

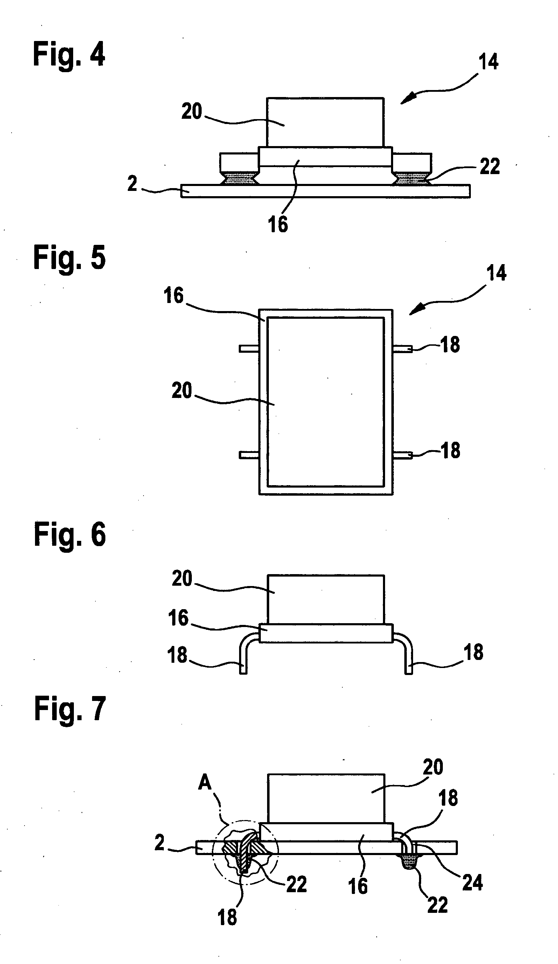

Während das in Fig. 2, 3 und 4 dargestellte Fixierelement 14 im Reflow-Lötverfahren auf der Leiterplatte 2 montiert wird, indem das verwendete Weichlot 22 vor der Bestückung der Leiterplatte 2 mit dem Fixierelement 14 unterhalb der vorgesehenen Auflageflächen der einstückig mit dem Grundträger verbundenen flachen Pins 18 auf die Oberseite der Leiterplatte 2 aufgebracht und bei der Bestückung mit dem Fixierelement 14 geschmolzen wird, wird das in Fig. 5, 6, 7 und 8 dargestellte Fixierelement 14 im herkömmlichen Lötverfahren auf der Leiterplatte 2 befestigt, indem die nach unten über den Grundträger 16 überstehenden umgebogenen drahtartigen Pins 18 von oben in entsprechende Durchgangsbohrungen 24 der Leiterplatte 2 eingeführt und durch Festlöten auf der Unterseite der Leiterplatte 2 starr mit derselben verbunden werden, sobald der Grundträger 16 anders als der Grundträger 16 des in Fig. 2, 3 und 4 dargestellten Fixierelements 14 mit seiner Unterseite auf der Oberseite der Leiterplatte 2 aufliegt (vgl. Fig. 7).

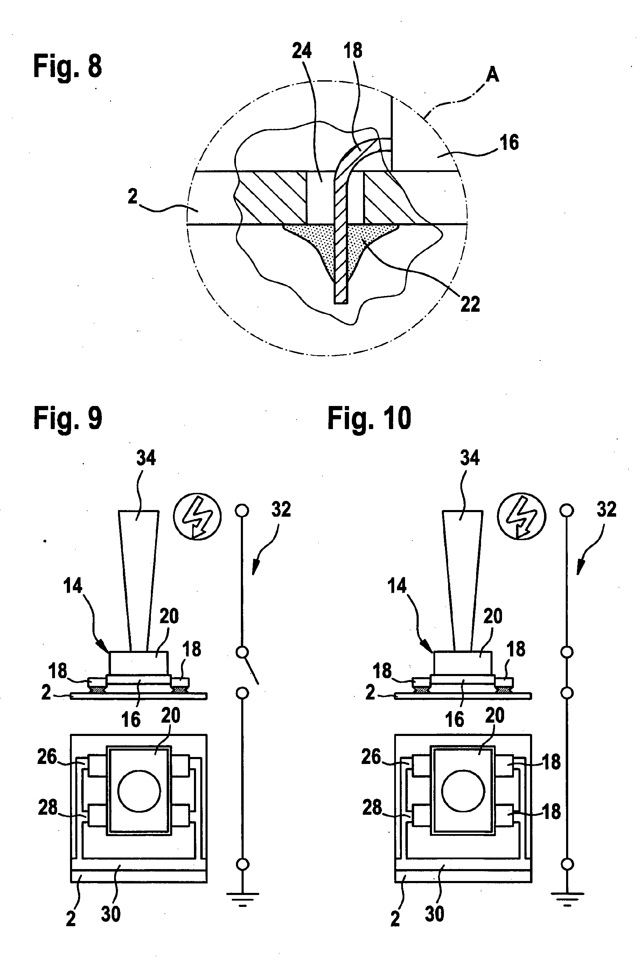

Im Unterschied zu den Fixierelementen 14 aus Fig. 1, die abseits der Leiterbahnen (nicht dargestellt) auf der Leiterplatte 2 befestigt sind, zeigen die Figuren 9 und 10 ein Fixierelement 14, dessen Pins 18 auf zwei Leiterbahnabschnitte 26, 28 aufgelötet sind, die mit einer an Masse gelegten Masseleiterbahn 30 parallel geschaltet sind. Während jedoch der Andruckteil 20 des in Fig. 9 dargestellten Fixierelements 14 ebenso wie die Andruckteile 20 der zuvor beschriebenen Fixierelemente 14 aus einem elektrisch nicht-leitenden Material besteht, so dass ein Strompfad 32 zwischen einem zum Festklemmen der Leiterplatte 2 dienenden, von oben gegen den Andruckteil 20 angepressten verjüngten Kontaktfinger 34 des Gehäuses einerseits und dem Masseleiter 30 der Leiterplatte 2 andererseits im Bereich des Andruckteils 20 unterbrochen ist, besteht der Andruckteil 20 des in Fig. 10 dargestellten Fixierelements 14 aus einem elektrisch leitenden Material, wie zum Beispiel einem mit Graphit gefüllten Elastomer, so dass über den Andruckteil 20 eine Kontaktierung zwischen dem Kontaktfinger 34 und dem Grundträger 16 des Fixierelements 14 hergestellt und somit der Strompfad 32 zwischen dem Kontaktfinger 34 und dem Masseleiter 30 beim Anpressen des Kontaktfingers 34 gegen den Andruckteil 20 des Fixierelements 14 geschlossen wird. Auf diese Weise können zum Beispiel mit dem Masseleiter 30 verbundene Masseanschlüsse der auf der Leiterplatte 2 montierten Komponenten 8, 10, 12 über den Kontaktfinger 34 mit einem außerhalb des Gehäuses liegenden externen Masseanschluss verbunden werden.

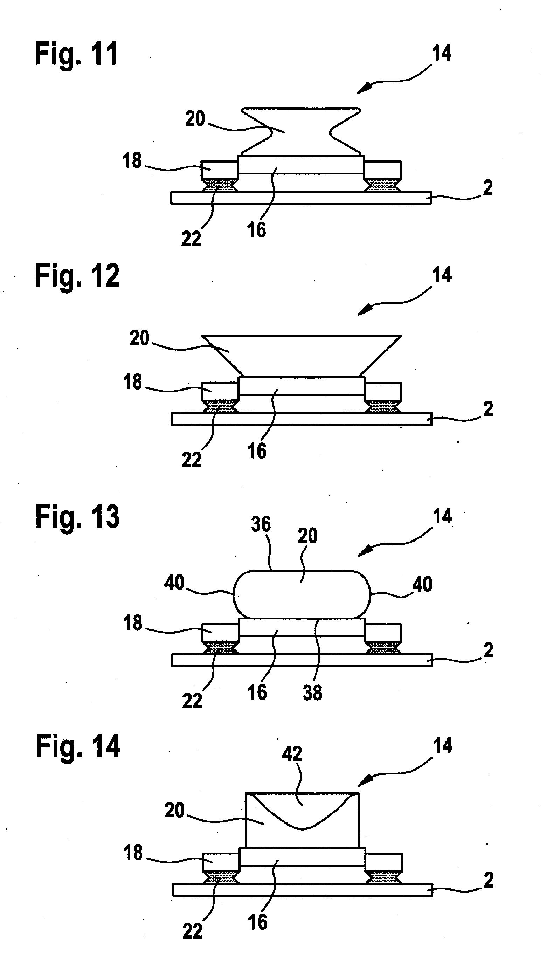

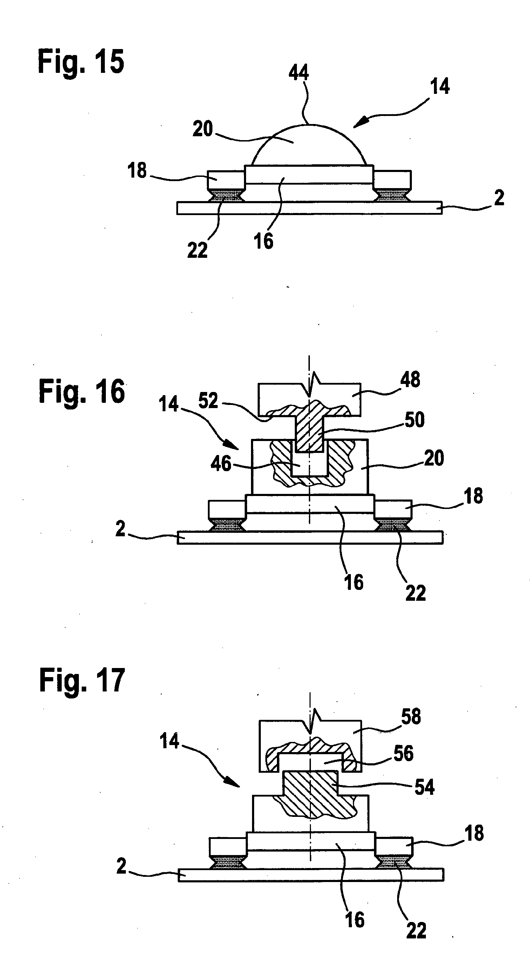

Während die Andruckteile 20 der in den Figuren 1 bis 10 dargestellten Fixierelemente 14 in unverformtem Zustand eine quaderförmige Gestalt aufweisen, kann es in Abhängigkeit vom jeweiligen Einsatzfall gegebenenfalls günstiger sein, den Andruckteilen 20 andere Formen zu geben, wie in den Figuren 11 bis 17 dargestellt. Erfindungsgemäß ist vorgesehen, dass die Andruckteile 20 wie beispielhaft in den Figuren 16 und 17 dargestellt, einen Vorsprung 54 bzw. eine Vertiefung 46 aufweisen, und der Vorsprung 54 bzw. die Vertiefung 46 des Andruckteils 20 mit einer Vertiefung 56 bzw. einem Vorsprung 50 des Gehäuses 48, 58 zusammenwirkt.

Zum Beispiel zeigt Fig. 11 ein Fixierelement 14 mit einem im Querschnitt ambossförmigen Andruckteil 20, mit dem sich eine eventuell vorhandene leichte Neigung zwischen der Oberseite der Leiterplatte 2 oder des Grundträgers 16 und einem ebenen, gegen die Oberseite des Andruckteils 20 anliegenden Gehäuseteil (nicht dargestellt) ausgleichen lässt. Dabei kann der Andruckteil 20 in Draufsicht einen quadratischen oder rechteckigen oder einen anderen nicht-rotationssymmetrischen Umriss aufweisen, wenn die Neigung nur in einer Richtung auftritt, bzw. einen runden Umriss, wenn die Neigung richtungsunspezifisch auftreten kann.

Fig. 12 zeigt ein Fixierelement mit einem im Querschnitt trapezförmigen Andruckteil 20, mit dem sich bei gleichem Flächeninhalt der Oberseite des Grundträgers 16 die Anlagefläche des Andruckteils 20 am Gehäuse maximieren lässt, zum Beispiel wenn der Andruckteil 20 mit seiner Oberseite direkt gegen die Unterseite eines Gehäusedeckels oder dergleichen anliegt.

Fig. 13 zeigt ein Fixierelement 14, dessen Andruckteil 20 zur Aufnahme von hohen Belastungen bzw. Klemmkräften einen Querschnitt mit einer ebenen Ober- und Unterseite 36, 38 und konvex gerundeten Seitenflächen 40 aufweist und vorzugsweise aus einem gummielastischen Material besteht, das durch eine auf die Oberseite 36 des Andruckteils 20 ausgeübte Klemmkraft F (vgl. Fig. 1) in vertikaler Richtung nur wenig zusammengedrückt wird.

Fig. 14 zeigt ein Fixierelement 14 mit einem zur Zentrierung der Leiterplatte 2 in Bezug zum Gehäuse dienenden Andruckteil 20, der in seiner Oberseite 36 mit einer rotationssymmetrischen Vertiefung 42 versehen ist, die mit einem komplementär geformten Stirnende (nicht dargestellt) eines Gehäusevorsprungs 6 oder Kontaktfingers 34 zusammenwirkt, um die Mittelachsen der Vertiefung 42 und des Gehäusevorsprungs zur Fluchtung zu bringen.

Fig. 15 zeigt ein Fixierelement 14, dessen Andruckteil 20 eine sphärische Oberfläche 44 aufweist und sich damit gut für undefinierte Einbaulagen eignet, in denen die auf den Andruckteil 20 ausgeübte Klemmkraft F (vgl. Fig. 1) in einer zur Ober- bzw. Unterseite der Leiterplatte nicht orthogonalen Richtung und/oder abseits von der Mitte auf den Andruckteil 20 des Fixierelements 14 aufgebracht wird.

Fig. 16 zeigt ein erfindungsgemäß ausgebildetes Fixierelement 14 mit einem Andruckteil 20, der mit einer zylindrischen Vertiefung 46 versehen ist, in die ein nach unten über einen Gehäuseteil 48 überstehender Dorn oder Zapfen 50 mit radialem Spiel eingreift, wenn eine den Dorn oder Zapfen 50 umgebende Ringschulter 52 um die Vertiefung 46 herum gegen die ebene Oberseite des Andruckteils 20 anliegt bzw. gegen diesen angepresst wird.

Ähnliches gilt auch für das in Fig. 17 dargestellte, erfindungsgemäß ausgebildete Fixierelement 14, dessen elastisch nachgiebiger Andruckteil 20 einen nach oben überstehenden zylindrischen Vorsprung 54 aufweist, der ebenfalls mit radialem Spiel in eine komplementäre Aufnahmevertiefung 56 eines mit dem Fixierelement 14 zusammenwirkenden Gehäuseteils 58 ragt, wenn der Gehäuseteil 58 zum Festklemmen der Leiterplatte 2 im Gehäuse von oben gegen den Andruckteil 20 des Fixierelements 14 angepresst wird. Im Unterschied zu dem Andruckteil aus Fig. 16 weisen der Vorsprung 54 und die Vertiefung 56 größere Querschnittsabmessungen auf und besitzen eine solche Höhe bzw. Tiefe, dass beim ersten Kontakt zwischen dem Gehäuseteil 58 und dem Andruckteil 20 nur die Stirnfläche des Vorsprungs 54 gegen den Boden der Vertiefung 56 angepresst wird und erst im Zuge einer beginnenden Kompression des Andruckteils 20 um die Vertiefung 56 bzw. den Vorsprung 54 herum ein Kontakt zwischen dem Gehäuseteil 58 und dem Andruckteil 20 hergestellt wird.

## Patentansprüche

1. Verfahren zur Fixierung einer Leiterplatte (2) in einem Gehäuse (48, 58), bei dem die Leiterplatte (2) im Gehäuse (48, 58) festgeklemmt wird, wobei die Leiterplatte (2) mit mindestens einem Fixierelement (14) bestückt wird, das einen elastisch nachgiebigen Andruckteil (20) umfasst, der beim Festklemmen der Leiterplatte (2) im Gehäuse mit einem Teil des Gehäuses (48, 58) zur Anlage gebracht und unter Verformung gegen diesen angepresst wird, wobei beim Festklemmen der Leiterplatte (2) im Gehäuse (48, 58) ein Vorsprung (54) bzw. eine Vertiefung (46) des Andruckteils (20) mit einer Vertiefung (56) bzw. einem Vorsprung (50) des Gehäuses (48, 58) zusammenwirkt, **dadurch gekennzeichnet, dass** der Vorsprung (50, 54) mit radialem Spiel in die Vertiefung (46, 56) eingreift und dass der Andruckteil (20) mindestens teilweise aus einem Elastomermaterial oder einem gummielastischen Material besteht.

2. Verfahren nach Anspruch 1, **dadurch gekennzeichnet, dass** das Fixierelement (14) durch Löten auf der Leiterplatte (2) befestigt wird.

3. Verfahren nach Anspruch 1, **dadurch gekennzeichnet, dass** das Fixierelement durch Kleben auf der Leiterplatte befestigt wird.

4. Anordnung mit einem Gehäuse (48, 58), einer Leiterplatte (2) und einem Fixierelement (14), wobei die Leiterplatte (2) in dem Gehäuse (48, 58) fixiert ist gemäß dem Verfahren nach einem der Ansprüche 1 bis 3, wobei das Fixierelement (14) Befestigungsmittel (18, 22) zur starren Befestigung auf der Leiterplatte (2), sowie ein elastisch nachgiebigen Andruckteil (20), der sich beim Festklemmen der Leiterplatte (2) im Gehäuse mit einem Teil des Gehäuses (48, 58) zur Anlage bringen und unter Verformung gegen diesen anpressen lässt, umfasst, wobei der Andruckteil (20) einen Vorsprung (54) oder eine Vertiefung (46) zum Zusammenwirken mit einer Vertiefung (56) bzw. einem Vorsprung (50) des Gehäuses (48, 58) aufweist, **dadurch gekennzeichnet, dass** der Vorsprung (50, 54) mit radialem Spiel in die Vertiefung (46, 56) eingreift und dass der Andruckteil (20) mindestens teilweise aus einem Elastomermaterial oder einem gummielastischen Material besteht.

5. Anordung nach Anspruch 4, **gekennzeichnet durch** einen starren Träger (18), der zur Befestigung auf der Leiterplatte (2) mit mindestens einem Teil (18) der Befestigungsmittel (18, 22) versehen ist und den elastisch nachgiebigen Andruckteil (20) trägt.

6. Anordnung nach Anspruch 4 oder 5, **dadurch gekennzeichnet, dass** die Befestigungsmittel einen Kleber zum Aufkleben des Fixierelements auf das Bauteil umfassen.

7. Anordnung nach Anspruch 4 oder 5, **dadurch gekennzeichnet, dass** die Befestigungsmittel (18, 22) eine Mehrzahl von Lötpins (18) umfassen, die über das Fixierelement (14) überstehen und durch Löten mit dem Bauteil (2) verbindbar sind.

8. Anordnung nach einem der Ansprüche 4 bis 7, **dadurch gekennzeichnet, dass** der Andruckteil (20) mindestens teilweise aus einem elektrisch leitenden Material besteht.

9. Anordnung nach einem der Ansprüche 4 bis 8, **dadurch gekennzeichnet, dass** der Andruckteil (20) gerundete oder teilsphärische Begrenzungsflächen (40, 44) aufweist.

## Claims

1. Method for fixing a printed circuit board (2) in a housing (48, 58), in which method the printed circuit board (2) is firmly clamped in the housing (48, 58), wherein the printed circuit board (2) is fitted with at least one fixing element (14) which comprises an elastically resilient contact-pressure part (20) which, when the printed circuit board (2) is firmly clamped in the housing, is brought into contact with a part of the housing (48, 58) and is pressed against the said part with deformation, wherein, when the printed circuit board (2) is firmly clamped in the housing (48, 58), a projection (54) or, respectively, a recess (46) of the contact-pressure part (20) interacts with a recess (56) or, respectively, a projection (50) of the housing (48, 58), **characterized in that** the projection (50, 54) engages into the recess (46, 56) with radial play, and **in that** the contact-pressure part (20) is at least partially composed of an elastomeric material or a rubber-elastic material.

2. Method according to Claim 1, **characterized in that** the fixing element (14) is fastened on the printed circuit board (2) by soldering.

3. Method according to Claim 1, **characterized in that** the fixing element is fastened on the printed circuit board by adhesive bonding.

4. Arrangement having a housing (48, 58), a printed circuit board (2) and a fixing element (14), wherein the printed circuit board (2) is fixed in the housing (48, 58) in line with the method according to one of Claims 1 to 3, wherein the fixing element (14) comprises fastening means (18, 22) for rigid fastening on the printed circuit board (2) and also comprises an elastically resilient contact-pressure part (20) which, when the printed circuit board (2) is firmly clamped in the housing, can be brought into contact with a part of the housing (48, 58) and can be pressed against the said part with deformation, wherein the contact-pressure part (20) has a projection (54) or a recess (46) for interacting with a recess (56) or, respectively, a projection (50) of the housing (48, 58), **characterized in that** the projection (50, 54) engages into the recess (46, 56) with radial play, and **in that** the contact-pressure part (20) is at least partially composed of an elastomeric material or a rubber-elastic material.

5. Arrangement according to Claim 4, **characterized by** a rigid support (18) which, for fastening on the printed circuit board (2), is provided with at least one part (18) of the fastening means (18, 22) and supports the elastically resilient contact-pressure part (20).

6. Arrangement according to Claim 4 or 5, **characterized in that** the fastening means comprise an adhesive for adhesively bonding the fixing element onto the component.

7. Arrangement according to Claim 4 or 5, **characterized in that** the fastening means (18, 22) comprise a plurality of soldering pins (18) which project beyond the fixing element (14) and can be connected to the component (2) by soldering.

8. Arrangement according to one of Claims 4 to 7, **characterized in that** the contact-pressure part (20) is at least partially composed of an electrically conductive material.

9. Arrangement according to one of Claims 4 to 8, **characterized in that** the contact pressure part (20) has rounded or partially spherical boundary surfaces (40, 44).

## Revendications

1. Procédé pour la fixation d'une carte de circuits imprimés (2) dans un boîtier (48, 58), dans lequel la carte de circuits imprimés (2) est serrée à bloc dans le boîtier (48, 58), dans lequel la carte de circuits imprimés (2) est garnie avec au moins un élément de fixation (14) qui comprend une partie d'application par pression (20) déformable élastiquement laquelle, lors du serrage à bloc de la carte de circuits imprimés (2) dans le boîtier, est amenée en appui contre une partie du boîtier (48, 58) et est pressée contre celle-ci par déformation, dans lequel, lors du serrage à bloc de la carte de circuits imprimés (2) dans le boîtier (48, 58), une saillie (54) ou un creux (46) de la partie d'application par pression (20) coopère avec un creux (56) ou une saillie (50) du boîtier (48, 58), **caractérisé en ce que** la saillie (50, 54) se met en prise avec un jeu radial dans le creux (46, 56) et **en ce que** la partie d'application par pression (20) se compose au moins partiellement d'un matériau élastomère ou d'un matériau élastique comme du caoutchouc.

2. Procédé selon la revendication 1, **caractérisé en ce que** l'élément de fixation (14) est fixé par soudage sur la carte de circuits imprimés (2).

3. Procédé selon la revendication 1, **caractérisé en ce que** l'élément de fixation est fixé par collage sur la carte de circuits imprimés.

4. Agencement avec un boîtier (48, 58), une carte de circuits imprimés (2) et un élément de fixation (14), dans lequel la carte de circuits imprimés (2) est fixée dans le boîtier (48, 58) conformément au procédé selon l'une des revendications 1 à 3, dans lequel l'élément de fixation (14) comprend des moyens de fixation (18, 22) pour la fixation rigide sur la carte de circuits imprimés (2) ainsi qu'une partie d'application par pression (20) déformable élastiquement laquelle, lors du serrage à bloc de la carte de circuits imprimés (2) dans le boîtier, peut être amenée en appui contre une partie du boîtier (48, 58) et être pressée contre celle-ci par déformation, dans lequel la partie d'application par pression (20) présente une saillie (54) ou un creux (46) pour la coopération avec un creux (56) ou une saillie (50) du boîtier (48, 58), **caractérisé en ce que** la saillie (50, 54) se met en prise avec un jeu radial dans le creux (46, 56) et **en ce que** la partie d'application par pression (20) se compose au moins partiellement d'un matériau élastomère ou d'un matériau élastique comme du caoutchouc.

5. Agencement selon la revendication 4, **caractérisé par** un support rigide (18), lequel est muni d'au moins une partie (18) des moyens de fixation (18, 22) pour la fixation sur la carte de circuits imprimés (2) et lequel porte la partie d'application par pression (20) déformable.

6. Agencement selon la revendication 4 ou 5, **caractérisé en ce que** les moyens de fixation comprennent une colle pour coller l'élément de fixation sur le composant.

7. Agencement selon la revendication 4 ou 5, **caractérisé en ce que** les moyens de fixation (18, 22) comprennent une pluralité de plots à souder (18) qui dépassent de l'élément de fixation (14) et peuvent être reliés par soudage au composant (2).

8. Agencement selon l'une des revendications 4 à 7, **caractérisé en ce que** la partie d'application par pression (20) se compose au moins partiellement d'un matériau électroconducteur.

9. Agencement selon l'une des revendications 4 à 8, **caractérisé en ce que** la partie d'application par pression (20) présente des surfaces de délimitation (40, 44) arrondies ou partiellement sphériques.
